# EUROPEAN PATENT APPLICATION

(11) **EP 4 601 018 A1**
(43) Date of publication of application: **13.08.2025**
(21) Application number: 22966853.8
(22) Date of filing: 30.11.2022
(51) Int. Cl.: H01L 31/042

(54) **THIN-FILM SOLAR CELL AND ELECTRIC DEVICE**

(71) Applicant: Contemporary Amperex Technology (Hong Kong) Limited, Central (HK)
(72) Inventor: GUO, Wenming, Ningde, Fujian 352100 (CN); CHEN, Guodong, Ningde, Fujian 352100 (CN); SU, Shuojian, Ningde, Fujian 352100 (CN); TU, Bao, Ningde, Fujian 352100 (CN); GUO, Yongsheng, Ningde, Fujian 352100 (CN); KONG, Xiangguang, Ningde, Fujian 352100 (CN)
(74) Representative: Gong, Jinping
(86) International application number: PCT/CN2022/135648
(87) International publication number: WO 2024/113262

(57) **Abstract**

This application provides a thin-film solar cell and an electric apparatus. The thin-film solar cell includes a plurality of cell units and an interconnection structure. The cell unit includes a first electrode layer, a second electrode layer, and a plurality of functional layers located between the first electrode layer and the second electrode layer. The interconnection structure includes a first isolation structure, a connection structure, and a second isolation structure. The connection structure is configured to connect the first electrode layer of a first cell unit and the second electrode layer of a second cell unit among the plurality of cell units, the first cell unit and the second cell unit being adjacent to each other; the first isolation structure is configured to isolate the first electrode layer of the first cell unit from the first electrode layer of the second cell unit, and isolate at least one of the functional layers of the first cell unit from the connection structure, and the second isolation structure is configured to isolate the second electrode layer of the first cell unit from the second electrode layer of the second cell unit, and isolate at least one of the functional layers of the second cell unit from the connection structure. The technical solution of this application is beneficial for improving output power.

## Description

### TECHNICAL FIELD

This application relates to the technical field of solar cells, and particularly to a thin-film solar cell and an electric apparatus.

### BACKGROUND

Thin-film solar cells are photovoltaic devices that generate electricity directly from sunlight, characterized by their small mass, thin thinness, flexibility, and low raw material costs. In recent years, thin-film solar cells have developed rapidly and have an increasing share in the photovoltaic power generation field.

A thin-film solar cell includes a plurality of cell units, where the plurality of cell units are electrically connected through an interconnection structure, and the arrangement of such interconnection structure affects the output power of the cell units. Therefore, how to provide a thin-film solar cell to increase its output power is an urgent technical problem to be solved.

### SUMMARY

This application is conducted in view of the preceding problem, and aim to provide a thin-film solar cell so as to increase the output power of the thin-film solar cell.

To achieve the above objective, this application provides a thin-film solar cell and an electric apparatus.

According to a first aspect, this application provides a thin-film solar cell, including: a plurality of cell units arranged in a first direction, where a plurality of cell units arranged in a first direction, where the cell unit includes a first electrode layer, a second electrode layer, and a plurality of functional layers located between the first electrode layer and the second electrode layer, arranged in a second direction; and an interconnection structure, where the connection structure includes a first isolation structure, a connection structure, and a second isolation structure; the connection structure is configured to connect the first electrode layer of a first cell unit and the second electrode layer of a second cell unit among the plurality of cell units, the first cell unit and the second cell unit being adjacent to each other; the first isolation structure is configured to isolate the first electrode layer of the first cell unit from the first electrode layer of the second cell unit, and isolate at least one of the functional layers of the first cell unit from the connection structure, and the second isolation structure is configured to isolate the second electrode layer of the first cell unit from the second electrode layer of the second cell unit, and isolate at least one of the functional layers of the second cell unit from the connection structure.

In an embodiment of this application, the thin-film solar cell includes a plurality of cell units arranged in a first direction and an interconnection structure. The cell unit includes a first electrode layer, a second electrode layer, and a plurality of functional layers located between the first electrode layer and the second electrode layer, arranged in a second direction. In this way, the cell unit can output power through the first electrode layer and the second electrode layer, and implement charge transport and light absorption through the plurality of functional layers. The interconnection structure includes a first isolation structure, a connection structure, and a second isolation structure. The connection structure is configured to connect the first electrode layer of a first cell unit and the second electrode layer of a second cell unit among the plurality of cell units, the first cell unit and the second cell unit being adjacent to each other, thereby enabling electrical connection between adjacent cell units. The first isolation structure is configured to isolate the first electrode layer of the first cell unit from the first electrode layer of the second cell unit, and isolate at least one of the functional layers of the first cell unit from the connection structure. This can implement the isolation or insulation between the first electrode layers of adjacent cell units, and can prevent the stability of the functional layers from decreasing caused by the connection structure being in contact with at least one of the functional layers, thereby avoiding the loss of photocurrent or output power. The second isolation structure is configured to isolate the second electrode layer of the first cell unit from the second electrode layer of the second cell unit, and isolate at least one of the functional layers of the second cell unit from the connection structure. This can implement the insulation between the second electrode layers of adjacent cell units, and can prevent the stability of the functional layers from decreasing caused by the connection structure being in contact with at least one of the functional layers, thereby avoiding the loss of photocurrent or output power. Therefore, the technical solution of this application can help reduce or avoid the loss of output power of the cell units, and help increase the output power of the thin-film solar cell.

In a possible implementation, the functional layer includes a light absorption layer, and the first isolation structure is configured to isolate the light absorption layer from the connection structure. This can prevent the reduction of effective substances in the light absorption layer caused by reactions between the connection structure and the light absorption layer, and thus helps enhance the stability of the light absorption layer and the cell unit, and helps increase he output power of the thin-film solar cell.

In a possible implementation, the cell unit includes the first electrode layer, a first charge transport layer, a first light absorption layer, a second charge transport layer, and the second electrode layer sequentially arranged on a substrate, where the first isolation structure is configured to isolate the connection structure from the first charge transport layer, the first light absorption layer, and the second charge transport layer. In this way, the first isolation structure may isolate the connection structure from the first charge transport layer, first light absorption layer, and second charge transport layer of the cell unit, to prevent reactions between the connection structure and the first light absorption layer, which helps increase the output power of the thin-film solar cell.

In a possible implementation, the cell unit further includes a third electrode layer, a third charge transport layer, a second light absorption layer, and a fourth charge transport layer sequentially arranged between the second charge transport layer and the second electrode layer, where the first isolation structure is configured to isolate the connection structure from the third electrode layer, the third charge transport layer, the second light absorption layer, and the fourth charge transport layer. In this way, the first isolation structure can isolate the connection structure from the third electrode layer, third charge transport layer, second light absorption layer, and fourth charge transport layer of the cell unit. The isolation between the connection structure and the third electrode layer avoids the loss of photocurrent caused by the contact between the connection structure and the third electrode layer; moreover, the isolation between the connection structure and the second light absorption layer prevents reactions between the connection structure and the second light absorption layer, which helps enhance the stability of the second light absorption layer.

In a possible implementation, the first isolation structure is an insulating structure extending from the second electrode layer to the substrate in the second direction. This ensures the isolation effect between the connection structure and the light absorption layer or the third electrode layer, and avoids the loss of photocurrent.

In a possible implementation, the insulating structure includes a first insulating wall extending from a first surface of the second electrode layer to a first surface of the substrate in the second direction, where the first surface of the second electrode layer is a surface of the second electrode layer far from the first electrode layer, and the first surface of the substrate is a surface of the substrate close to the first electrode layer. This facilitates the production of the insulating structure. After all the film layers in the cell unit are prepared, the insulating structure can be produced through etching and filling treatments, which helps reduce manufacturing steps and decrease production costs.

In a possible implementation, the second electrode layer protrudes from the first isolation structure in the second direction at a position corresponding to the first isolation structure, to cause the connection structure to be electrically connected to the second electrode layer. This can ensure the electrical connection between the connection structure and the second electrode layer.

In a possible implementation, in the first direction, a distance between the connection structure and the first isolation structure is greater than 0. This can reduce the difficulty in preparing the connection structure and the first isolation structure, and facilitate the preparation of the connection structure and the first isolation structure.

In a possible implementation, in the first direction, a size of the first isolation structure is 10 µm to 80 µm. This can balance the isolation effect of the first isolation structure and the volume of the thin-film solar cell.

In a possible implementation, a material of the first insulating wall includes at least one of epoxy resin, melamine formaldehyde resin, polycarbonate polymethyl methacrylate, polyethylene, polytetrafluoroethylene, phenolic plastic, silicon boron, a metal oxide, and an ionic-structured inorganic solid. This facilitates the flexible selection of the material of the first insulating wall according to actual conditions.

In a possible implementation, the first isolation structure includes a second insulating wall and a first insulating layer, where the second insulating wall extends from a second surface of the first electrode layer to a first surface of the first electrode layer in the second direction, the first insulating layer is attached to a side of the connection structure close to the second insulating wall, the first surface of the first electrode layer is a surface of the first electrode layer far from the substrate, and the second surface of the first electrode layer is a surface of the first electrode layer close to the substrate. This can ensure the insulation effect of the first isolation structure.

In a possible implementation, the second isolation structure is a groove extending from the second electrode layer to the first electrode layer in the second direction. This can enable isolation between adjacent cell units.

In a possible implementation, the second isolation structure extends from the first surface of the second electrode layer to the first surface of the first electrode layer in the second direction, where the first surface of the second electrode layer is a surface of the second electrode layer far from the first electrode layer, and the first surface of the first electrode layer is a surface of the first electrode layer far from the substrate. This facilitates the preparation of the second isolation structure.

In a possible implementation, in the first direction, a size of the second isolation structure is 30 µm to 100 µm. This can balance the isolation effect of the second isolation structure and the volume of the thin-film solar cell.

In a possible implementation, in the first direction, a distance between the first isolation structure and the second isolation structure is 200 µm to 300 µm. This can reduce the difficulty in preparing the first isolation structure and the second isolation structure. For example, this can prevent the connection between the first isolation structure and the second isolation structure caused by line crossing or skewing during preparation of the first isolation structure and the second isolation structure through scribing.

In a possible implementation, in the first direction, a size of the connection structure is 30 µm to 100 µm. This can balance the conductive performance of the connection structure and the volume of the thin-film solar cell.

In a possible implementation, in the first direction, a size of the cell unit is 6 mm to 10 mm. This facilitates the partition and preparation of the cell units.

In a possible implementation, a bandgap of the first light absorption layer is greater than a bandgap of the second light absorption layer. This helps improve the absorption efficiency of the light absorption layer, thereby improving the photoelectric conversion efficiency.

In a possible implementation, both the first light absorption layer and the second light absorption layer are perovskite layers. This facilitates the preparation of the first light absorption layer and the second light absorption layer, and helps reduce the difficulty of preparation.

In a possible implementation, the first light absorption layer is a copper indium gallium selenium layer, and the second light absorption layer is a perovskite layer. This helps enhance the stability of the thin-film solar cell.

In a possible implementation, a thickness of the first charge transport layer is 10 nm to 30 nm, a thickness of the first light absorption layer is 100 nm to 400 nm, a thickness of the second charge transport layer is 20 nm to 60 nm, a thickness of the third electrode layer is 1 nm to 3 nm, a thickness of the third charge transport layer is 10 nm to 30 nm, a thickness of the second light absorption layer is 600 nm to 800 nm, a thickness of the fourth charge transport layer is 30 nm to 50 nm, and a thickness of the second electrode layer is 100 nm to 200 nm. This facilitates the flexible selection of thicknesses of various layers according to actual needs.

According to a second aspect, this application provides an electric apparatus, including the thin-film solar cell according to any one of the first aspect and the possible implementations of the first aspect, where the thin-film solar cell is configured to supply power to the electric apparatus.

In an embodiment of this application, the thin-film solar cell includes a plurality of cell units arranged in a first direction and an interconnection structure. The cell unit includes a first electrode layer, a second electrode layer, and a plurality of functional layers located between the first electrode layer and the second electrode layer, arranged in a second direction. In this way, the cell unit can output power through the first electrode layer and the second electrode layer, and implement charge transport and light absorption through the plurality of functional layers. The interconnection structure includes a first isolation structure, a connection structure, and a second isolation structure. The connection structure is configured to connect the first electrode layer of a first cell unit and the second electrode layer of a second cell unit among the plurality of cell units, the first cell unit and the second cell unit being adjacent to each other, thereby enabling electrical connection between adjacent cell units. The first isolation structure is configured to isolate the first electrode layer of the first cell unit from the first electrode layer of the second cell unit, and isolate at least one of the functional layers of the first cell unit from the connection structure. This can implement the isolation or insulation between the first electrode layers of adjacent cell units, and can prevent the stability of the functional layers from decreasing caused by the connection structure being in contact with at least one of the functional layers, thereby avoiding the loss of photocurrent or output power. The second isolation structure is configured to isolate the second electrode layer of the first cell unit from the second electrode layer of the second cell unit, and isolate at least one of the functional layers of the second cell unit from the connection structure. This can implement the insulation between the second electrode layers of adjacent cell units, and can prevent the stability of the functional layers from decreasing caused by the connection structure being in contact with at least one of the functional layers, thereby avoiding the loss of photocurrent or output power. Therefore, the technical solution of this application can help reduce or avoid the loss of output power of the cell units, and help increase the output power of the thin-film solar cell.

### BRIEF DESCRIPTION OF DRAWINGS

FIG. 1 is a schematic diagram of a thin-film solar cell according to an embodiment of this application;
FIG. 2 is a schematic diagram of a thin-film solar cell according to an embodiment of this application;
FIG. 3 is a schematic cross-sectional diagram of a thin-film solar cell according to an embodiment of this application;
FIG. 4 is a schematic cross-sectional diagram of a cell unit of the thin-film solar cell in FIG. 3;
FIG. 5 is a lateral view of a cell unit of the thin-film solar cell in FIG. 3;
FIG. 6 is a schematic diagram of a thin-film solar cell according to an embodiment of this application;
FIG. 7 is a schematic diagram of a thin-film solar cell according to an embodiment of this application;
FIG. 8 is a schematic diagram of an electric apparatus according to an embodiment of this application; and
FIG. 9 is a schematic diagram of a method for preparing a thin-film solar cell according to an embodiment of this application.

### DESCRIPTION OF EMBODIMENTS

The following specifically discloses in detail embodiments of the thin-film solar cell, the electric apparatus, and the method for preparing a thin-film solar cell of this application, with appropriate reference to the accompanying drawings. However, there may be cases in which unnecessary detailed descriptions are omitted. For example, detailed descriptions of well-known matters and repeated descriptions of actually identical structures have been omitted. This is to avoid unnecessarily prolonging the following descriptions, for ease of understanding by persons skilled in the art. In addition, the accompanying drawings and the following descriptions are provided for those skilled in the art to fully understand this application and are not intended to limit the subject described in the claims.

"Ranges" disclosed in this application are defined in the form of lower and upper limits. A given range is defined by one lower limit and one upper limit selected, where the selected lower and upper limits define boundaries of that special range. Ranges defined in this way may or may not include end values, and any combination may be used, meaning that any lower limit may be combined with any upper limit to form a range. For example, if ranges of 60-120 and 80-110 are provided for a specific parameter, it is understood that ranges of 60-110 and 80-120 can also be envisioned. In addition, if low limit values of a range are given as 1 and 2, and upper limit values of the range are given as 3, 4, and 5, the following ranges can all be envisioned: 1-3, 1-4, 1-5, 2-3, 2-4, and 2-5. In this application, unless otherwise stated, a value range of "a-b" is a short representation of any combination of real numbers between a and b, where both a and b are real numbers. For example, a value range of "0-5" means that all real numbers in the range of "0-5" are listed herein and "0-5" is just a short representation of combinations of these values. In addition, a parameter expressed as an integer greater than or equal to 2 is equivalent to disclosure that the parameter is, for example, an integer among 2, 3, 4, 5, 6, 7, 8, 9, 10, 11, 12, and so on.

Unless otherwise stated, all the embodiments and optional embodiments of this application can be combined with each other to form new technical solutions.

Unless otherwise stated, all the technical features and optional technical features of this application can be combined with each other to form new technical solutions.

Unless otherwise stated, all the steps in this application can be performed sequentially or randomly, preferably, performed sequentially. For example, the method including steps (a) and (b) indicates that the method may include steps (a) and (b) performed sequentially or may include steps (b) and (a) performed sequentially. For example, the foregoing method may further include step (c), which indicates that step (c) may be added to the method in any ordinal position, for example, the method may include steps (a), (b), and (c), steps (a), (c), and (b), steps (c), (a), and (b), or the like.

Unless otherwise stated, "include" and "contain" mentioned in this application are inclusive or may be exclusive. For example, the terms "include" and "contain" can mean that other unlisted components may also be included or contained, or only listed components are included or contained.

Unless otherwise stated, in this application, the term "or" is inclusive. For example, the phrase "A or B" means "A, B, or both A and B". More specifically, any one of the following conditions satisfies the condition "A or B": A is true (or present) and B is false (or not present); A is false (or not present) and B is true (or present); or both A and B are true (or present).

Thin-film solar cells are photovoltaic devices that generate electricity directly from sunlight. In recent years, with the gradual development of technology, the requirements for thin-film solar cells have become higher, among which the output power of thin-film solar cells is an important performance. A thin-film solar cell includes a plurality of cell units and an interconnection structure, where the plurality of cell units are electrically connected through an interconnection structure. The interconnection structure includes a first isolation structure that isolates first electrode layers of adjacent cell units, a connection structure that connects adjacent cell units, and a second isolation structure that isolates second electrode layers of adjacent cell units.

The applicant has discovered through research that when the connection structure comes into contact with functional layers of the cell units, a reaction occurs between the connection structure and the functional layers, which destabilizes the functional layers, resulting in a loss of photocurrent of the cell units and hindering the increase in the output power of the thin-film solar cell.

In view of this, this application provides a thin-film solar cell, which isolates a connection structure from at least one of functional layers in a cell unit, so as to avoid or reduce the loss of photocurrent, thereby increasing the output power of the thin-film solar cell.

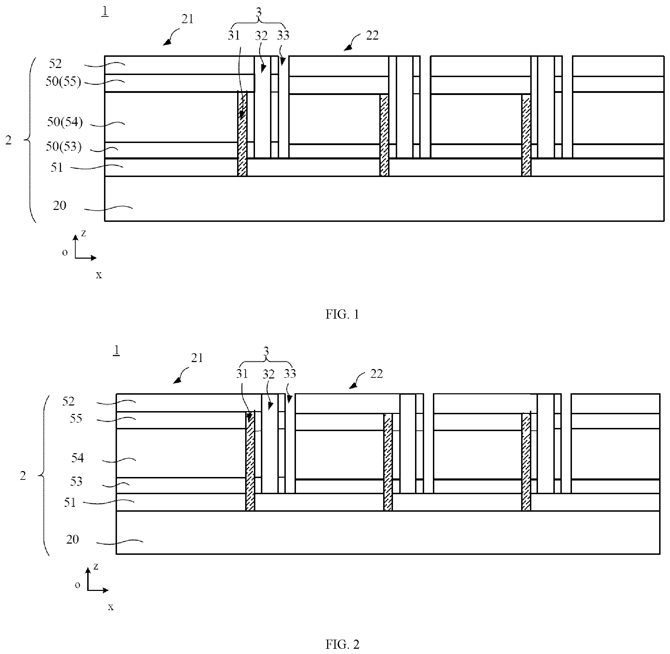

FIG. 1 is a schematic diagram of a thin-film solar cell according to an embodiment of this application. As shown in FIG. 1, the thin-film solar cell 1 includes a plurality of cell units 2 arranged in a first direction and an interconnection structure 3.

The first direction is an arrangement direction of the plurality of cell units 2, for example, direction x in FIG. 1.

The cell unit 2 includes a first electrode layer 51, a second electrode layer 52, and a plurality of functional layers 50 located between the first electrode layer 51 and the second electrode layer 52, arranged in a second direction. The second direction is perpendicular to the first direction, for example, direction z in FIG. 1.

The first electrode layer 51 and the second electrode layer 52 are configured to implement the power output of the cell unit 2.

Optionally, the first electrode layer 51 is a transparent conductive oxide layer. For example, the first electrode layer 51 is indium tin oxide (Indium Tin Oxide, ITO), and a thickness of the first electrode layer 51 is 200 nm to 300 nm. As another example, the first electrode layer 51 is fluorine-doped tin oxide, and a thickness of the first electrode layer 51 is 500 nm to 600 nm.

Optionally, the second electrode layer 52 is a metal electrode layer. For example, a material of the second electrode layer 52 is Cu.

The functional layer 50 is configured to enable the cell unit 2 to implement the function of generating electricity using solar light. The functional layer 50 may include a charge transport layer for transporting carriers, such as holes or electrons; and the functional layer 50 may further include a light absorption layer, where the light absorption layer is capable of generating electron-hole pairs upon exposure to solar radiation.

The interconnection structure 3 includes a first isolation structure 31, a connection structure 32, and a second isolation structure 33.

The connection structure 32 is configured to connect the first electrode layer 51 of a first cell unit 21 and the second electrode layer 52 of a second cell unit 22 among the plurality of cell units 2, the first cell unit 21 and the second cell unit 22 being adjacent to each other. To be specific, the plurality of cell units 2 include adjacent first cell unit 21 and second cell unit 22, and the connection structure 32 is configured to connect the first electrode layer 51 of the first cell unit 21 and the second electrode layer 52 of the second cell unit 22, so as to implement series connection between the first cell unit 21 and the second cell unit 22.

The first isolation structure 31 is configured to isolate the first electrode layer 51 of the first cell unit 21 from the first electrode layer 51 of the second cell unit 22, and isolate at least one of the functional layers 50 of the first cell unit 21 from the connection structure 32. For example, under the condition that the cell unit 2 includes three functional layers 50, the first isolation structure 31 may isolate one functional layer 50, or may isolate two functional layers 50, or even may isolate three functional layers 50. As another example, the first isolation structure 31 may isolate two adjacent functional layers 50, or may isolate two functional layers 50 that are spaced apart from each other.

Such arrangement of the first isolation structure 31 can avoid direct contact or electrical connection between the first electrode layers 51 of adjacent cell units 2, and can also avoid contact between the connection structure 32 and at least one of the functional layer 50 of the first cell unit 21, so as to prevent a decrease in the stability of the functional layers 50 caused by reactions between the connection structure 32 and the at least one of the functional layers 50, which helps enhance the stability of the thin-film solar cell 1.

The second isolation structure 33 is configured to isolate the second electrode layer 52 of the first cell unit 21 from the second electrode layer 52 of the second cell unit 22, and isolate at least one of the functional layers 50 of the second cell unit 22 from the connection structure 32. This can avoid direct contact or electrical connection between the second electrode layers 52 of adjacent cell units 2, and can also prevent contact between the connection structure 32 and at least one of the functional layers 50 of the second cell unit 22, which helps enhance the stability of the functional layer 50 and the thin-film solar cell 1.

In an embodiment of this application, the thin-film solar cell 1 includes a plurality of cell units 2 arranged in a first direction and an interconnection structure 3. The cell unit 2 includes a first electrode layer 51, a second electrode layer 52, and a plurality of functional layers 50 located between the first electrode layer 51 and the second electrode layer 52, arranged in a second direction. In this way, the second cell unit 52 can output power through the first electrode layer 51 and the second electrode layer 52, and implement charge transport and light absorption through the plurality of functional layers 50. The interconnection structure 3 includes a first isolation structure 31, a connection structure 32, and a second isolation structure 33. The connection structure 32 is configured to connect the first electrode layer 51 of a first cell unit 21 and the second electrode layer 52 of a second cell unit 22 among the plurality of cell units 2, the first cell unit 21 and the second cell unit 22 being adjacent to each other, thereby enabling electrical connection between adjacent cell units 2. The first isolation structure 31 is configured to isolate the first electrode layer 51 of the first cell unit 21 from the first electrode layer 51 of the second cell unit 22, and isolate at least one of the functional layers 50 of the first cell unit 21 from the connection structure 32. This can implement the isolation or insulation between the first electrode layers 51 of adjacent second cell units 2, and can prevent the stability of the functional layers 50 from decreasing caused by the connection structure 32 being in contact with at least one of the functional layers 50, thereby avoiding the loss of photocurrent or output power. The second isolation structure 33 is configured to isolate the second electrode layer 52 of the first cell unit 21 from the second electrode layer 52 of the second cell unit 22, and isolate at least one of the functional layers 50 of the second cell unit 22 from the connection structure 32. This can implement the isolation or insulation between the second electrode layers 52 of adjacent cell units 2, and can prevent the stability of the functional layers 50 from decreasing caused by the connection structure 32 being in contact with at least one of the functional layers 50, thereby avoiding the loss of photocurrent or output power. Therefore, the technical solution of this application helps reduce or avoid the loss of output power of the cell units 2, and helps increase the output power of the thin-film solar cell 1.

In some embodiments, the functional layer 50 includes a light absorption layer, and the first isolation structure 31 is configured to isolate the light absorption layer from the connection structure 32.

The light absorption layer may also be called a photosensitive layer, and the light absorption layer is capable of generating electron-hole pairs upon exposure to solar radiation. A material of the light absorption layer may be perovskite, copper indium gallium selenium, cadmium telluride, or the like.

In this embodiment, this can prevent the reduction of effective substances in the light absorption layer caused by reactions between the connection structure 32 and the light absorption layer, and thus helps enhance the stability of the light absorption layer and the cell unit 2, and helps increase he output power of the thin-film solar cell 1.

FIG. 2 is a schematic diagram of a thin-film solar cell according to an embodiment of this application. In some embodiments, as shown in FIG. 2, the cell unit 2 includes the first electrode layer 51, a first charge transport layer 53, a first light absorption layer 54, a second charge transport layer 55, and the second electrode layer 52 sequentially arranged on a substrate 20, and the first isolation structure 31 is configured to isolate the connection structure 32 from the first charge transport layer 53, the first light absorption layer 54, and the second charge transport layer 55.

Sequential arrangement means arranged in order, and does not necessarily mean adjacent to each other. For example, the second charge transport layer 55 and the second electrode layer 52 are sequentially arranged, meaning that the second charge transport layer 55 is closer to the substrate with respect to the second electrode layer 52, and the second charge transport layer 55 and the second electrode layer 52 may directly become into contact with each other, or other functional layers may be arranged between the second charge transport layer 55 and the second electrode layer 52.

The cell unit 2 includes the first electrode layer 51, a first charge transport layer 53, a first light absorption layer 54, a second charge transport layer 55, and the second electrode layer 52 sequentially arranged on a substrate 20, which also means that in the cell unit 2, the substrate 20, the first electrode layer 51, the first charge transport layer 53, the first light absorption layer 54, the second charge transport layer 55, and the second electrode layer 52 are arranged from bottom to top.

The first charge transport layer 53 and the second charge transport layer 54 are configured to transport carriers. Optionally, the first charge transport layer 53 is a hole transport layer, and the second charge transport layer 55 is an electron transport layer. Optionally, the first charge transport layer 53 is an electron transport layer, and the second charge transport layer 55 is a hole transport layer.

The first isolation structure 31 is configured to isolate the connection structure 32 from the cell unit 2.

Optionally, the first light absorption layer 54 is a perovskite layer. Such arrangement of the isolation structure 31 can also isolate the perovskite layer from the connection structure 32. For example, the connection structure 32 is a conductive material containing silver ions, where the silver ions react with iodine ions in the perovskite, accelerating the decomposition of the perovskite and leading to a decrease in the power of the cell unit 2. Such arrangement of the isolation structure 31 to isolate the first light absorption layer 54 of the perovskite from the connection structure 32 can avoid the decomposition of the perovskite, and help maintain or increase the output power of the thin-film solar cell.

In this embodiment, the first isolation structure 31 can isolate the connection structure 32 from the first charge transport layer 53, first light absorption layer 54, and second charge transport layer 55 of the second cell unit 2, to prevent reactions between the connection structure 32 and the first light absorption layer 54, which helps increase the output power of the thin-film solar cell 1.

Optionally, the first isolation structure 31 can also isolate only the connection structure 32 from the first light absorption layer 54 of the cell unit 2, without isolating the connection structure 32 from the first charge transport layer 53 and second charge transport layer 55 of the cell unit 2. Optionally, the first isolation structure isolates only the connection structure 32 from the first light absorption layer 54 and first charge transport layer 53 of the cell unit 2, without isolating the connection structure 32 from the second charge transport layer 55 of the cell unit 2. Optionally, the first isolation structure isolates only the connection structure 32 from the first light absorption layer 54 and second charge transport layer 55 of the cell unit 2, without isolating the connection structure 32 from the first charge transport layer 53 of the cell unit 2.

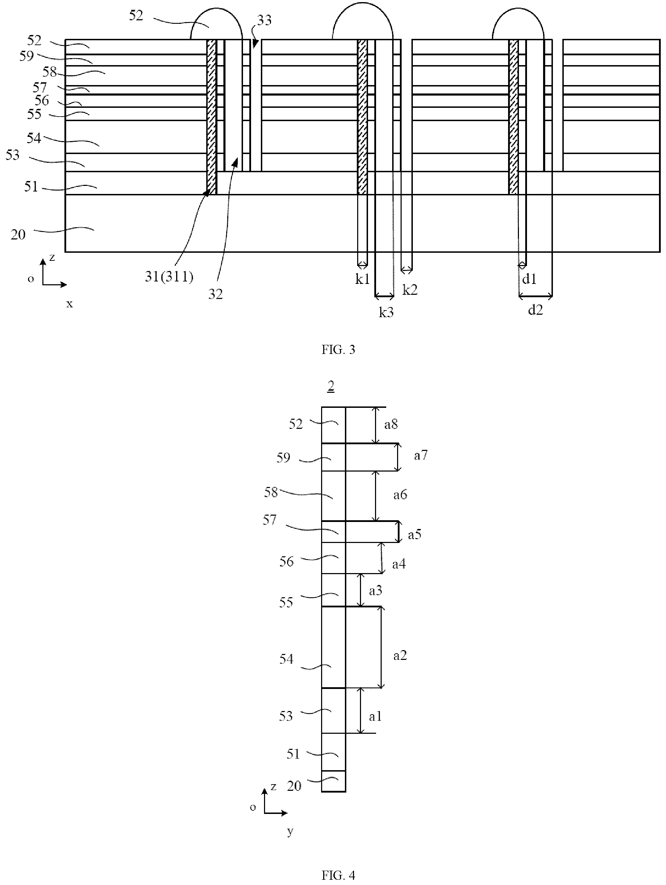

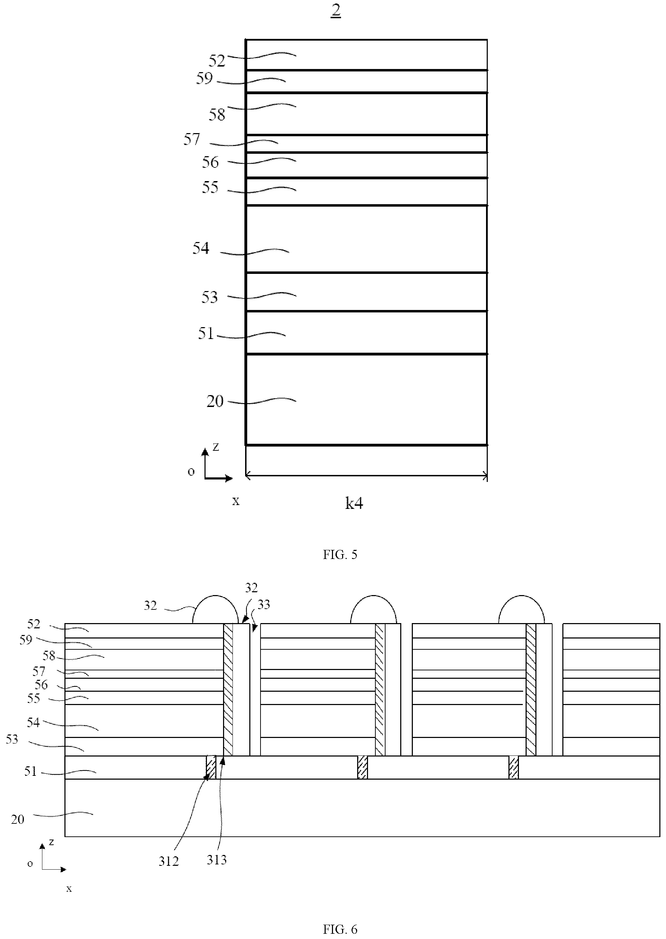

FIG. 3 is a schematic cross-sectional diagram of a thin-film solar cell according to an embodiment of this application; FIG. 4 is a schematic cross-sectional diagram of a cell unit of the thin-film solar cell in FIG. 3; and FIG. 5 is a lateral view of a cell unit of the thin-film solar cell in FIG. 3. In some embodiments, as shown in FIG. 3 to FIG. 5, the cell unit 2 further includes a third electrode layer 56, a third charge transport layer 57, a second light absorption layer 58, and a fourth charge transport layer 59 sequentially arranged between the second charge transport layer 55 and the second electrode layer 52, and the first isolation structure 31 is configured to isolate the connection structure 32 from the third electrode layer 56, the third charge transport layer 57, the second light absorption layer 58, and the fourth charge transport layer 59.

The cell unit 2 shown in FIG. 3 may be called a cell unit of a laminated structure. The cell unit 2 includes at least two sub-cells, where one sub-cell includes a structure of electrode layer-charge transport layer-light absorption layer-charge transport layer-electrode layer. Optionally, the cell unit 2 may further include more than two sub-cells, such as 3, 4, or more.

The cell unit 2 may be a regular structure system or may be an inverted structure system. For example, when the cell unit 2 is a regular structure system, the first charge transport layer 53 is a hole transport layer, the second charge transport layer 55 is an electron transport layer, the third charge transport layer 57 is a hole transport layer, and the fourth charge transport layer 59 is an electron transport layer. When the cell unit 2 is an inverted structure system, the first charge transport layer 53 is an electron transport layer, the second charge transport layer 55 is a hole transport layer, the third charge transport layer 57 is an electron transport layer, and the fourth charge transport layer 59 is a hole transport layer.

A material of the electron transport layer may be zinc oxide, titanium oxide, tin oxide, carbon 60 (that is, C60), and a fullerene derivative (that is, PCBM), or the like. a material of the hole transport layer may be nickel oxide, poly[bis(4-phenyl)(2,4,6-trimethylphenyl)amine] (Poly[bis(4-phenyl)(2,4,6-trimethylphenyl)amine], PTAA), a polymer of 3-hexylthiophene (P3HT for short), 2,2',7,7'-tetrakis[N,N-di(4-methoxyphenyl)amino]-9,9'-spirobifluorene (Spiro-OMeTAD for short), or the like.

The first isolation structure 31 is configured to isolate the connection structure 32 from the plurality of functional layers in the cell unit 2, where the plurality of functional layers include the first charge transport layer 53, the first light absorption layer 54, the second charge transport layer 55, the third electrode layer 56, the third charge transport layer 57, the second light absorption layer 58, and the fourth charge transport layer 59.

In these embodiments, the first isolation structure 31 may isolate the connection structure 32 from the third electrode layer 56, third charge transport layer 57, second light absorption layer 58, and fourth charge transport layer 59 of the second cell unit 2. The isolation between the connection structure 32 and the third electrode layer 56 avoids the loss of photocurrent caused by the contact between the connection structure 32 and the third electrode layer 56; moreover, the isolation between the connection structure 32 and the second light absorption layer 58 prevents reactions between the connection structure 32 and the second light absorption layer 58, which helps enhance the stability of the second light absorption layer 58.

In some embodiments, the first isolation structure 31 is an insulating structure extending from the second electrode layer 52 to the substrate 20 in the second direction.

The first isolation structure 31 may be an insulating structure extending from a first surface or second surface of the second electrode layer 52 to a first surface or second surface of the substrate 20. In other words, the first isolation structure 31 has different lengths in the second direction, so that a suitable length may be selected according to actual needs. The first surface of the second electrode layer 52 is a surface of the second electrode layer 52 far from the first electrode layer 51, the second surface of the second electrode layer 52 is a surface of the second electrode layer 52 close to the first electrode layer 51, the first surface of the substrate 20 is a surface of the substrate 20 close to the first electrode layer 51, and the second surface of the substrate 20 is a surface of the substrate 20 far from the first electrode layer 51.

Optionally, the insulating structure is provided with an inorganic or organic insulating material.

In these embodiments, the first isolation structure 31 is an insulating structure extending from the second electrode layer 52 to the substrate 20 in the second direction. This can ensure the isolation effect between the connection structure 32 and the light absorption layer and/or the third electrode layer 56, avoid the loss of photocurrent, and enhance the stability of the cell unit 2, thereby increasing the power of the thin-film solar cell 1.

In some embodiments, the insulating structure includes a first insulating wall 311 extending from a first surface of the second electrode layer 52 to a first surface of the substrate 20 in the second direction, where the first surface of the second electrode layer 52 is a surface of the second electrode layer 52 far from the first electrode layer 51, and the first surface of the substrate 20 is a surface of the substrate close to the first electrode layer 51. This facilitates the production of the insulating structure. After all the film layers in the second cell unit 2 are prepared, the insulating structure can be produced through etching and filling treatments, which helps reduce manufacturing steps and decrease production costs.

In some embodiments, the second electrode layer 52 protrudes from the first isolation structure 31 in the second direction at a position corresponding to the first isolation structure 31, to cause the connection structure 32 to be electrically connected to the second electrode layer 52. This can ensure the electrical connection between the connection structure 32 and the second electrode layer 52.

Optionally, the connection structure 32 protrudes from the first isolation structure in the second direction at a position corresponding to the first isolation structure 31, to cause the connection structure 32 to be electrically connected to the second electrode layer 52. The connection structure 32 may be prepared by etching a corresponding layer in the cell unit 2 and filling or spraying an etched groove with a metal material or another conductive material.

Optionally, the first insulating wall 311 extends from the second surface of the second electrode layer 52 to the first surface of the substrate 20 in the second direction.

In some embodiments, in the first direction, a distance d1 between the connection structure 32 and the first isolation structure 31 is greater than 0.

The distance d1 between the connection structure 32 and the first isolation structure 31 or the first insulating wall 311 is a minimum vertical distance.

In these embodiments, the film layers of the cell unit 2 may be etched through laser scribing or mechanical scribing to form corresponding grooves, and then the corresponding grooves are filled with insulating materials and conductive materials to form the first insulating wall 311 and the connection structure 32, respectively. By setting the distance between the connection structure 32 and the first isolation structure 31 in the first direction to be greater than 0, the difficulty of scribing can be reduced. This, in turn, reduces the difficulty of preparing the connection structure 32 and the first isolation structure 31 and facilitates the preparation of the connection structure 32 and the first isolation structure 31.

In some embodiments, in the first direction, a size k1 of the first isolation structure 31 is 10 µm to 80 µm.

When the size k1 of the first isolation structure 31 is less than 10 µm, the isolation effect of the first isolation structure 31 fails to meet the needs, and the preparation of the first isolation structure 31 is complicated; and when the size k1 of the first isolation structure 31 is greater than 80 µm, although the first isolation structure 31 has a good isolation effect, it occupies a large space. As a result, the volume of the thin-film solar cell 1 becomes larger, which is not conducive to increasing the energy density. By setting the size k1 of the first isolation structure 31 in the first direction to 10 µm to 80 µm, both the isolation effect of the first isolation structure 31 and the volume of the thin-film solar cell 1 can be balanced.

In some embodiments, a material of the first insulating wall 311 includes a solid insulating material, an organic insulating material, or an inorganic insulating material. For example, the organic insulating material may include one or more of epoxy resin, melamine formaldehyde resin, polycarbonate polymethyl methacrylate, polyethylene, polytetrafluoroethylene, phenolic plastic, and the like. The inorganic insulating material may include silicon boron, various metal oxides, and the like. The inorganic insulating material may further include an inorganic solid having an ionic structure, an inorganic solid primarily having an ionic structure, and the like. This facilitates the flexible selection of the material of the first insulating wall according to actual conditions.

FIG. 6 is a schematic diagram of a thin-film solar cell according to an embodiment of this application. In some embodiments, as shown in FIG. 6, the first isolation structure 31 includes a second insulating wall 312 and a first insulating layer 313.

The second insulating wall 312 extends from a second surface of the first electrode layer 51 to a first surface of the first electrode layer 51 in the second direction, where the first surface of the first electrode layer 51 is a surface of the first electrode layer 51 far from the substrate, and the second surface of the first electrode layer 51 is a surface of the first electrode layer 51 close to the substrate. In this way, the insulation between the first electrode layers 51 of adjacent cell units 2 can be implemented using the second insulating wall 312.

The first insulating layer 313 is attached to a side of the connection structure 32 close to the second insulating wall 312. Such arrangement of the first insulating layer 313 implements the insulation between the connection structure 32 and the electrode layer, light absorption layer, and charge transport layer of the cell unit 2.

Optionally, the first insulating layer 313 may be formed, after all the film layers of the cell unit 2 are prepared, by etching corresponding layers to form grooves and filling the grooves with insulating materials on the side close to the second insulating wall 312. After the first insulating layer 312 is prepared, the grooves are filled with a wire material to prepare the connection structure 32. The connection structure 32 protrudes from the first insulating layer 313 in the second direction at a position corresponding to the first insulating layer 313, so as to implement electrical connection between the second electrode layer 52 and the connection structure 32.

Optionally, the first insulating layer 313 is attached to a side of the connection structure 32 close to the second insulating wall 312 through bonding.

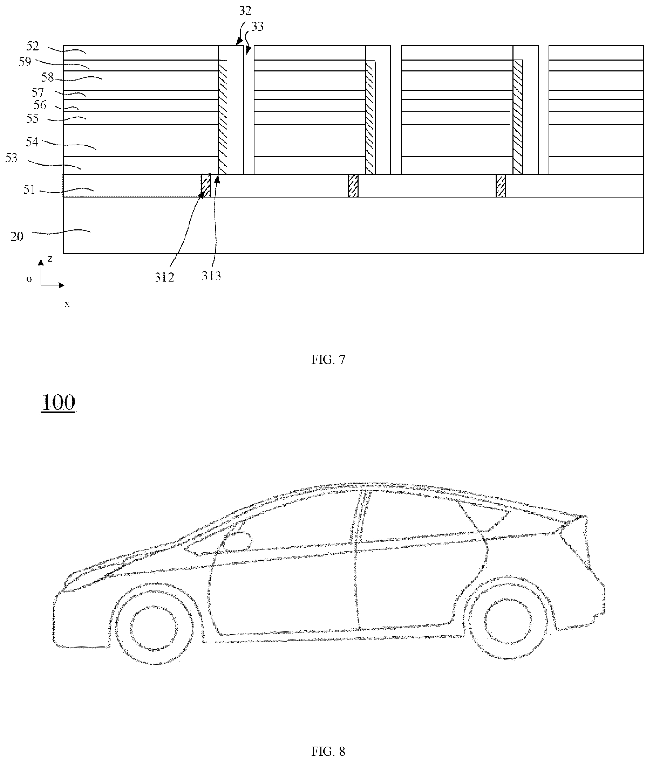

FIG. 7 is a schematic diagram of a thin-film solar cell according to an embodiment of this application. Optionally, in some embodiments, as shown in FIG. 7, the first insulating layer 313 extends from a second surface of the second electrode layer 52 to a first surface of the first electrode layer 51, where the first surface of the first electrode layer 51 is a surface of the first electrode layer 51 far from the substrate.

Optionally, in the first direction, a distance between the first insulating layer 313 and the second insulating wall 312 is greater than 0.

In some embodiments, the second isolation structure 33 is a groove extending from the second electrode layer 52 to the first electrode layer 51 in the second direction. This can enable isolation between adjacent second cell units 2.

In some embodiments, the second isolation structure 33 extends from a first surface of the second electrode layer 52 to a first surface of the first electrode layer 51 in the second direction, where the first surface of the second electrode layer 52 is a surface of the second electrode layer 52 far from the first electrode layer 51, and the first surface of the first electrode layer 51 is a surface of the first electrode layer 51 far from the substrate 20. This facilitates the preparation of the second isolation structure 33.

Optionally, the second isolation structure 33 extends from a first surface of the second electrode layer 52 to a second surface of the first electrode layer 51 in the second direction, where the second surface of the first electrode layer 51 is a surface of the first electrode layer 51 close to the substrate 20.

Optionally, the second isolation structure 33 includes a third insulating wall and a second insulating layer, where the third insulating wall extends from a first surface of the second electrode layer 52 to a second surface of the second electrode layer 52 in the second direction, and the second insulating layer is attached to a side of the connection structure 32 close to the third insulating wall.

In some embodiments, in the first direction, a size k2 of the second isolation structure 33 is 30 µm to 100 µm. This can balance the isolation effect of the second isolation structure 33 and the volume of the thin-film solar cell 1.

In some embodiments, in the first direction, a distance d2 between the first isolation structure 31 and the second isolation structure 33 is 100 µm to 300 µm, and optionally 200 µm to 300 µm. This can reduce the difficulty in preparing the first isolation structure 31 and the second isolation structure 33. For example, this can prevent the connection between the first isolation structure 31 and the second isolation structure 33 caused by line crossing or skewing during preparation of the first isolation structure 31 and the second isolation structure 33 through scribing.

The distance d2 between the first isolation structure 31 and the second isolation structure 33 is a minimum vertical distance therebetween in the first direction.

In some embodiments, in the first direction, a size k3 of the connection structure 32 is 30 µm to 150 µm, and optionally 30 µm to 100 µm. This can balance the conductive performance of the connection structure 32 and the volume of the thin-film solar cell.

In some embodiments, in the first direction, a size k4 of the cell unit 2 is 6 mm to 10 mm. This facilitates the partition and preparation of the cell units 2.

In some embodiments, a bandgap of the first light absorption layer 54 is greater than a bandgap of the second light absorption layer 58.

After solar light is incident on the substrate 20, as the bandgap of the first light absorption layer 54 is greater than the bandgap of the second light absorption layer 58, the first light absorption layer 54 absorbs short-wavelength light, and the second light absorption layer 58 absorbs long-wavelength light. Consequently, it is possible to maximize the conversion of light energy into electrical energy and increase the utilization rate of solar light. Therefore, such arrangement helps improve the absorption efficiency of the light absorption layer, thereby improving the photoelectric conversion efficiency.

In some embodiments, both the first light absorption layer 54 and the second light absorption layer 58 are perovskite layers. This facilitates the preparation of the first light absorption layer 54 and the second light absorption layer 58 when they are made of the same material, and helps reduce the difficulty of preparation.

Optionally, the bandgap of the first light absorption layer 54 is 1.6 eV to 1.9 eV, and the bandgap of the second light absorption layer 58 is 0.8 eV to 1.3 eV.

Optionally, a material of the first light absorption layer 54 is FA_{0.83}Cs_{0.17}Pb(I_{0.5}Br_{0.5})₃; and a material of the second light absorption layer 58 is FA_{0.75}Cs_{0.25}Sn_{0.5}Pb_{0.5}I₃.

Optionally, a material of the first light absorption layer 54 is Cs_{0.35}FA_{0.65}PbI_{1.8}Br_{1.2}, and a material of the second light absorption layer 58 is FA_{0.7}WA_{0.3}Pb_{0.5}Sn_{0.5}I₃.

In some embodiments, the first light absorption layer 54 is a copper indium gallium selenium (Copper Indium Gallium Selenium, CIGS) layer, and the second light absorption layer 58 is a perovskite layer, for example, the second light absorption layer 58 is Cs_{0.09}FA_{0.77}MA_{0.14}Pb(I_{0.86}Br_{0.14})₃. In this way, such arrangement of the first light absorption layer 54 being a copper indium gallium selenium layer helps improve the photoelectric conversion efficiency of the thin-film solar cell.

In some embodiments, a thickness a1 of the first charge transport layer 53 is 10 nm to 30 nm, a thickness a2 of the first light absorption layer 54 is 100 nm to 400 nm, a thickness a3 of the second charge transport layer 55 is 20 nm to 60 nm, a thickness a4 of the third electrode layer 56 is 1 nm to 3 nm, a thickness a5 of the third charge transport layer 57 is 10 nm to 30 nm, a thickness a6 of the second light absorption layer 58 is 600 nm to 800 nm, a thickness a7 of the fourth charge transport layer 59 is 30 nm to 50 nm, and a thickness a8 of the second electrode layer 52 is 100 nm to 200 nm. This facilitates the flexible selection of thicknesses of various layers according to actual needs.

Although this application has been described with reference to some preferred embodiments, various modifications to this application and replacements of the components therein with equivalents can be made without departing from the scope of this application. In particular, as long as there is no structural conflict, the various technical features mentioned in the embodiments can be combined in any manner.

This application provides an electric apparatus, including any one of the thin-film solar cells 1 described above, where the thin-film solar cell 1 is configured to supply power to the electric apparatus.

FIG. 8 is a schematic diagram of an electric apparatus according to an embodiment of this application. As shown in FIG. 8, the electric apparatus is a vehicle 100, and the thin-film solar cell 1 is arranged on the vehicle and configured to supply power to the vehicle or the battery in the vehicle.

Optionally, the electric apparatus may alternatively be another device such as a street light or a power storage station.

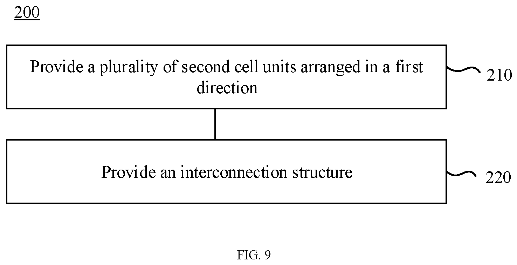

FIG. 9 is a schematic diagram of a method for preparing a thin-film solar cell according to an embodiment of this application. As shown in FIG. 9, the method 200 includes Step 210 and Step 220.

Step 210: Provide a plurality of second cell units 2 arranged in a first direction. The second cell unit 2 includes a first electrode layer 51, a second electrode layer 52, and a plurality of functional layers located between the first electrode layer 51 and the second electrode layer 52, arranged in a second direction.

Step 220: Provide an interconnection structure 3. The interconnection structure 3 includes a first isolation structure 31, a connection structure 32, and a second isolation structure 33. The connection structure 32 is configured to connect the first electrode layer 51 of a first second cell unit 22 and the second electrode layer 52 of a second second cell unit 2022 among the plurality of second cell units 2, the first second cell unit 22 and the second second cell unit 2022 being adjacent to each other; the first isolation structure 31 is configured to isolate the first electrode layer 51 of the first second cell unit 22 from the first electrode layer 51 of the second cell unit 2022, and isolate at least one of the functional layers of the first second cell unit 22 from the connection structure 32; and the second isolation structure 33 is configured to isolate the second electrode layer 52 of the first second cell unit 22 from the second electrode layer 52 of the second second cell unit 2022, and isolate at least one of the functional layers of the second second cell unit 2022 from the connection structure 32.

The thin-film solar cell 1 prepared by the method 200 has a high output power.

In some embodiments, step 220 includes: etching the second electrode layer 52, the plurality of functional layers, and the first electrode layer 51 in the second direction to expose a substrate to form a first groove, and filling the first groove with an insulating material to prepare the first isolation structure 31; etching the second electrode layer 52 and the plurality of functional layers in the second direction to expose the first electrode layer 51 to form a second groove, and arranging a conductive material in the second groove and on a surface of the first isolation structure 31 to prepare the connection structure 32; and etching the second electrode layer 52 and the plurality of functional layers in the second direction to expose the first electrode layer 51 to prepare the second isolation structure 33. In this way, the etching treatment can be performed after all the film layers are prepared, which helps reduce the preparation difficulty, simplify the preparation process, and reduce production costs.

In some embodiments, step 210 includes: providing a substrate 20, where a first electrode layer 51 is arranged on the substrate 20; depositing poly[bis (4-phenyl) (2,4,6-trimethylphenyl)amine] on the first electrode layer 51 to prepare a first charge transport layer 53; depositing perovskite on the first charge transport layer 53 to prepare a first light absorption layer 54; sequentially depositing C60 and SnO2 on the first light absorption layer 54 to prepare a second charge transport layer 55; depositing Au on the second charge transport layer 55 to prepare a third electrode layer 56; depositing poly(3,4-ethylenedioxythiophene)-polystyrene sulfonate on the third electrode layer 56 to prepare a third charge transport layer 57; depositing perovskite on the third charge transport layer 57 to prepare a second light absorption layer 58, where a bandgap of the second light absorption layer 58 is smaller than a bandgap of the first light absorption layer 54; sequentially depositing C60 and 2,9-dimethyl-4,7-diphenyl-1,10-phenanthroline on the second light absorption layer 58 to prepare a fourth charge transport layer 59; and depositing Cu on the fourth charge transport layer 59 to prepare a second electrode layer 52. This simple preparation method helps reduce the preparation difficulty and reduce the production costs.

Optionally, the electrode layers, charge transport layers, and light absorption layers on the substrate 20 are prepared through thermal evaporation or thermal deposition.

Optionally, the etching is performed through laser scribing or mechanical scribing.

In some embodiments, a thickness of poly[bis (4-phenyl) (2,4,6-trimethylphenyl)amine] is 18 nm to 22 nm, a thickness of the first light absorption layer is 280 nm to 320 nm; a thickness of C60 in the second charge transport layer is 18 nm to 22 nm, a thickness of SnO2 is 18 nm to 22 nm; a thickness of Au is 1 nm to 3 nm; a thickness of the bandgap of the second light absorption layer is 600 nm to 800 nm; a thickness of C60 in the fourth charge transport layer is 28 nm to 32 nm, a thickness of 2,9-dimethyl-4,7-diphenyl-1,10-phenanthroline is 6 nm to 8 nm; and a thickness of Cu is 140 nm to 160 nm. This facilitates the flexible selection of thicknesses of various layers according to actual needs.

### Example

The following describes examples of this application. The examples described below are illustrative and only used to explain this application, and cannot be construed as limitations on this application. Examples whose techniques or conditions are not specified are made in accordance with techniques or conditions described in literature in the field, or made in accordance with product instructions. In the following examples, the effective power generation area of the thin-film solar cell is 12 cm², and the number of cell units is 7.

### Example 1

Example 1 corresponds to the structure shown in FIG. 1 of this application, and the preparation process of Example 1 is as follows.
(1) A piece of 80 mm × 80 mm indium tin oxide (Indium Tin Oxide, ITO) conductive glass was taken, and the ITO conductive glass served as a substrate 20 provided with a first electrode layer 51. A thickness of the first electrode layer 51 was 250 nm.
(2) The ITO conductive glass was cleaned, and a 20 nm layer of PTAA was prepared on the ITO conductive glass to serve as a first charge transport layer 53.
(3) A 300 nm perovskite layer was prepared on the first charge transport layer 51 to prepare a first light absorption layer 54. A material of the first light absorption layer 54 was FACsPb(Br_{0.13}I_{0.87})₃.
(4) The first light absorption layer 54 was etched in the second direction to expose the substrate 20 to form a first groove; polycarbonate polymethyl methacrylate was deposited in the first groove to serve as an insulating material to prepare a first isolation structure 31.
(5) 20 nm of C60 was deposited on the first light absorption layer 54 to prepare a second charge transport layer 55.
(6) The second charge transport layer 55 was etched in the second direction to expose the first electrode layer 51 to form a second groove; and 150 nm of Cu was deposited in the second groove and on the second charge transport layer 55 to prepare a connection structure 32 and a second electrode layer 52, respectively.
(7) The second electrode layer 52 was etched in the second direction to expose the first electrode layer 51 to prepare a second isolation structure 33.

### Example 2

Example 2 corresponds to the structure shown in FIG. 2 of this application. A difference from Example 1 is that, in Example 2, in the second direction, the first isolation structure 31 ran through the second charge transport layer 55, the first light absorption layer 54, the first charge transport layer 53, and the first electrode layer 51.

### Example 3

Example 3 corresponds to the structure shown in FIG. 3 of this application. A difference from Example 1 lies in that, in Example 3, the thin-film solar cell was a laminated cell. The preparation process of Example 3 is as follows.
(1) A piece of 80 mm × 80 mm indium tin oxide (Indium Tin Oxide, ITO) conductive glass was taken, and the ITO conductive glass served as a substrate 20 provided with a first electrode layer 51. A thickness of the first electrode layer 51 was 500 nm.
(2) The ITO conductive glass was cleaned, and a 20 nm layer of PTAA was prepared on the ITO conductive glass to serve as a first charge transport layer 53.
(3) A 300 nm perovskite layer was prepared on the first charge transport layer 51 to prepare a first light absorption layer 54. A material of the first light absorption layer 54 was Cs_{0.35}FA_{0.65}PbI_{1.8}Br_{1.2}.
(4) 20 nm of C60 was prepared on the first light absorption layer 54 using a thermal evaporation method, to prepare a second charge transport layer 55.
(5) 20 nm of SnO2 was produced on the second charge transport layer 55 using an atomic layer deposition method, to serve as a dense layer.
(6) 2 nm of Au was deposited on the dense layer using a thermal evaporation method, to serve as a tunneling composite layer to prepare a third electrode layer 56.
(7) 20 nm of PEDOT:PSS was prepared on the third electrode layer 56 to prepare a third charge transport layer 57.
(8)A 700 nm perovskite layer was prepared on the third charge transport layer 57 to prepare a second light absorption layer 58. A material of the second light absorption layer 58 is FA_{0.7}MA_{0.3}Pb_{0.5}Sn_{0.5}I₃.
(9) 30 nm of C60 and 7 nm of BCP were prepared on the second light absorption layer 58 using a thermal evaporation method, to serve as a fourth charge transport layer 59.
(10) 150 nm of Cu was deposited on the fourth charge transport layer 59 using a thermal evaporation method, to serve as a second electrode layer 52.
(11) The second electrode layer 52 was etched in the second direction to expose the substrate 20 to form a first groove. Polycarbonate polymethyl methacrylate was deposited in the first groove to serve as an insulating material to prepare a first isolation structure 31. A size k1 of the first isolation structure 31 in the first direction was 30 µm.
(12) The second electrode layer 52 was etched in the second direction to expose the first electrode layer 51 to form a second groove. Cu was deposited in the second groove to prepare a connection structure 32; and Cu was deposited on part of a surface of the second electrode layer 52 to cause the second electrode layer 52 to electrically connect the connection structure 32. In the first direction, a size k3 of the connection structure 32 was 80 µm.
(13) The second electrode layer 52 was etched in the second direction to expose the first electrode layer 51 to prepare a second isolation structure 33. In the first direction, a size k2 of the second isolation structure 33 was 50 µm, a distance d2 between the first isolation structure 31 and the second isolation structure 33 was 250 µm, and a size k4 of the cell unit 2 was 8 mm.

### Example 4

Example 4 corresponds to the structure shown in FIG. 6 of this application. A difference from Example 3 is that, in Example 4, the first isolation structure of Example 3 was the first insulating wall 311, while the first isolation structure 31 of Example 4 was the second insulating wall 312 and the first insulating layer 313.

The first insulating layer 313 could be attached to a side of the second groove close to the second insulating wall 312 after the second groove was formed.

### Example 5

Example 5 corresponds to the structure shown in FIG. 7 of this application. A difference from Example 4 is that, in Example 5, the first insulating layer 313 was not attached to the second electrode layer 52.

### Examples 6 to 9

A difference from Example 3 is that, in Examples 6 to 9, the sizes of the first isolation structures 31 in the first direction were different. In Examples 6 to 9, the sizes k1 of the first isolation structures 31 in the first direction were 10 µm, 20 µm, 60 µm, and 80 µm, respectively.

### Examples 10 to 12

A difference from Example 3 is that, in Examples 10 to 12, the sizes of the second isolation structures 33 in the first direction were different. In Examples 10 to 12, the sizes k2 of the second isolation structures 33 in the first direction were 30 µm, 60 µm, and 100 µm, respectively.

### Examples 13 and 14

A difference from Example 3 is that, in Examples 13 and 14, the distances d2 between the first isolation structures 31 and the second isolation structures 33 in the first direction were different. In Examples 13 and 14, d2s were 200 µm and 300 µm, respectively.

### Examples 15 to 17

A difference from Example 3 is that, in Examples 15 to 17, the sizes k3 of the connection structures 32 in the first direction were different. In Examples 15 to 17, k3s were 30 µm, 80 µm, and 100 µm, respectively.

### Examples 18 and 19

A difference from Example 3 is that, in Examples 18 and 19, the sizes k4 of the cell units 2 in the first direction were different. In Examples 18 to 19, k4s were 6 mm and 10 mm, respectively.

### Example 20

A difference from Example 3 is that, in Example 20, the materials of the first light absorption layer 54 and the second light absorption layer 58 were different. In Example 20, the substrate 20 was a glass substrate, the first conductive layer 51 was Mo, the first charge transport layer 53 was PTAA, the first light absorption layer 54 was CIGS, the second charge transport layer 55 was ZnO2, the third electrode layer 56 was indium tin oxide, the third charge transport layer 57 was PTAA, the second light absorption layer 58 was Cs_{0.09}FA_{0.77}MA_{0.14}Pb(I_{0.86}Br_{0.14})₃, the fourth charge transport layer 59 was PCBM, and the second electrode layer 52 was indium tin oxide.

### Examples 21 and 22

In Examples 21 and 22, differences from Example 3 are the thickness a1 of the first charge transport layer 53, the thickness a2 of the first light absorption layer 54, the thickness a3 of the second charge transport layer 55, the thickness a4 of the third electrode layer 56, the thickness a5 of the third charge transport layer 57, the thickness a6 of the second light absorption layer 58, the thickness a7 of the fourth charge transport layer 59, and the thickness a8 of the second electrode layer 52. The specific data of various layers are shown in Table 1.

**Table 1 Specific data of Example 3 and Examples 21-22**

| | a1 (nm) | a2 (nm) | a3 (nm) | a4 (nm) | a5 (nm) | a6 (nm) | a7 (nm) | a8 (nm) |
|---|---|---|---|---|---|---|---|---|
| Example 3 | 20 | 300 | 20 | 2 | 20 | 700 | 37 | 150 |
| Example 21 | 10 | 100 | 40 | 1 | 10 | 600 | 30 | 100 |
| Example 22 | 30 | 400 | 60 | 3 | 30 | 800 | 50 | 200 |

### Comparative Example 1

A difference between Comparative Example 1 and Example 1 is that the connection structure in Comparative Example 1 was not isolated from the first light absorption layer.

### Comparative Example 2

A difference between Comparative Example 2 and Example 3 is that the connection structure in Comparative Example 2 was not isolated from the third electrode layer, the first light absorption layer, and the second light absorption layer.

### Test method

The performance of the thin-film solar cells prepared in the examples and comparative examples was tested experimentally. The specific operation process is as follows: Under the irradiation of standard simulated solar light (AM 1.5G, 100 mW/cm²), the performance of the cells was tested to obtain an I-V curve. According to the I-V curve and the data fed back from the testing equipment, the short-circuit current Jsc (unit: mA/cm2), the open-circuit voltage Voc (unit: V), maximum light output current Jmpp (unit: mA), and the maximum light output voltage Vmpp (unit: V) could be obtained. The fill factor FF of the cell was calculated using the formula FF=Jsc×Voc/(Jmpp×Vmpp), unit: %. The photoelectric conversion efficiency PCE of the cell was calculated using the formula PCE=Jsc×Voc×FF/Pin, unit: %; where Pᵢₙ represents the input power of the incident light, unit: mW.

### Test results

The test results of the examples and comparative examples are shown in Table 2.

**Table 2 Test results of comparative examples and examples**

| | Jsc (mA·cm-2) | Voc (V) | FF (%) | PCE (%) |
|---|---|---|---|---|
| Comparative Example 1 | 2.34 | 6.92 | 53.49 | 8.66 |
| Comparative Example 2 | 1.02 | 11.6 | 57.01 | 6.75 |
| Example 1 | 2.67 | 7.21 | 62.31 | 12 |
| Example 2 | 2.65 | 7.25 | 62.35 | 11.98 |
| Example 3 | 1.92 | 13.63 | 71 | 18.58 |
| Example 4 | 1.68 | 13.35 | 69.38 | 15.56 |
| Example 5 | 1.72 | 13.24 | 69.45 | 15.58 |
| Example 6 | 1.87 | 13.61 | 70.32 | 17.89 |
| Example 7 | 1.89 | 13.58 | 70.23 | 18.02 |
| Example 8 | 1.86 | 13.56 | 70.15 | 17.69 |
| Example 9 | 1.83 | 13.51 | 70.09 | 17.33 |
| Example 10 | 1.84 | 13.59 | 69.83 | 17.46 |
| Example 11 | 1.86 | 13.61 | 69.88 | 17.68 |
| Example 12 | 1.89 | 13.62 | 69.97 | 18.01 |
| Example 13 | 1.79 | 13.58 | 70.26 | 17.08 |
| Example 14 | 1.82 | 13.59 | 70.34 | 17.40 |
| Example 15 | 1.65 | 13.48 | 69.65 | 15.49 |
| Example 16 | 1.85 | 13.55 | 70.23 | 17.60 |
| Example 17 | 1.89 | 13.62 | 70.65 | 18.19 |
| Example 18 | 1.76 | 13.53 | 70.56 | 16.8 |
| Example 19 | 1.98 | 13.32 | 63.79 | 16.82 |
| Example 20 | 1.68 | 12.39 | 62.17 | 12.94 |
| Example 21 | 1.86 | 13.59 | 69.56 | 17.58 |
| Example 22 | 1.78 | 13.54 | 69.87 | 16.84 |

A larger photoelectric conversion efficiency PCE indicates a greater output power of the thin-film solar cell.

Combining Comparative Example 1 with Examples 1 and 2, it can be learned that by isolating the connection structure from at least one of the functional layers, the cells have a greater photoelectric conversion efficiency and output power.

Combining Comparative Example 2 with Examples 3 to 22, it can be learned that by isolating the connection structure from at least one of the functional layers, the cells have a greater photoelectric conversion efficiency and output power.

Combining Examples 1 and 2 with Examples 3 to 22, it can be learned that thin-film solar cells having a laminated structure have higher photoelectric conversion efficiency and output power.

Combining Example 3 with Examples 6 to 19, it can be learned that by reasonably setting the sizes of the first isolation structure 31, the second isolation structure 33, the connection structure 32, and the cell unit 2, it is possible to reduce the complexity of the preparation process while maintaining a high photoelectric conversion efficiency.

Combining Example 3 with Example 20, it can be learned that the structure of the thin-film solar cell in this application can be applied to various types of light absorption layers.

Combining Example 3 with Examples 21 and 22, it can be learned that by reasonably setting the thicknesses of various functional layers, it is possible to maintain a high photoelectric conversion efficiency while ensuring the normal function of the cell.

It should be noted that this application is not limited to the foregoing embodiments. The foregoing embodiments are merely examples, and embodiments having substantially the same constructions and the same effects as the technical idea within the scope of the technical solutions of this application are all included in the technical scope of this application. In addition, without departing from the essence of this application, various modifications made to the embodiments that can be conceived by persons skilled in the art, and other manners constructed by combining some of the constituent elements in the embodiments are also included in the scope of this application.

## Claims

1. A thin-film solar cell (1), **characterized by** comprising:
a plurality of cell units (2) arranged in a first direction, wherein the cell unit (2) comprises a first electrode layer (51), a second electrode layer (52), and a plurality of functional layers (50) located between the first electrode layer (51) and the second electrode layer (52), arranged in a second direction;
an interconnection structure (3), wherein the interconnection structure (3) comprises a first isolation structure (31), a connection structure (32), and a second isolation structure (33); the connection structure (32) is configured to connect the first electrode layer (51) of a first cell unit (21) and the second electrode layer (52) of a second cell unit (22) among the plurality of cell units (2), the first cell unit (21) and the second cell unit (22) being adjacent to each other; the first isolation structure (31) is configured to isolate the first electrode layer (51) of the first cell unit (21) from the first electrode layer (51) of the second cell unit (22), and isolate at least one of the functional layers (50) of the first cell unit (21) from the connection structure (32); and the second isolation structure (33) is configured to isolate the second electrode layer (52) of the first cell unit (21) from the second electrode layer (52) of the second cell unit (22), and isolate at least one of the functional layers (50) of the second cell unit (22) from the connection structure (32).

2. The thin-film solar cell (1) according to claim 1, **characterized in that** the functional layer (50) comprises a light absorption layer, and the first isolation structure (31) is configured to isolate the light absorption layer from the connection structure (32).

3. The thin-film solar cell (1) according to claim 1 or 2, **characterized in that** the cell unit (2) comprises the first electrode layer (51), a first charge transport layer (53), a first light absorption layer (54), a second charge transport layer (55), and the second electrode layer (52) sequentially arranged on a substrate (20), and the first isolation structure (31) is configured to isolate the connection structure (32) from the first charge transport layer (53), the first light absorption layer (54), and the second charge transport layer (55).

4. The thin-film solar cell (1) according to claim 3, **characterized in that** the cell unit (2) further comprises a third electrode layer (56), a third charge transport layer (57), a second light absorption layer (58), and a fourth charge transport layer (59) sequentially arranged between the second charge transport layer (55) and the second electrode layer (52), and the first isolation structure (31) is configured to isolate the connection structure (32) from the third electrode layer (56), the third charge transport layer (57), the second light absorption layer (58), and the fourth charge transport layer (59).

5. The thin-film solar cell (1) according to claim 3 or 4, **characterized in that** the first isolation structure (31) is an insulating structure extending from the second electrode layer (52) to the substrate (20) in the second direction.

6. The thin-film solar cell (1) according to claim 5, **characterized in that** the insulating structure comprises a first insulating wall (311) extending from a first surface of the second electrode layer (52) to a first surface of the substrate (20) in the second direction, wherein the first surface of the second electrode layer (52) is a surface of the second electrode layer (52) far from the first electrode layer (51), and the first surface of the substrate (20) is a surface of the substrate (20) close to the first electrode layer (51).

7. The thin-film solar cell (1) according to claim 6, **characterized in that** the second electrode layer (52) protrudes from the first isolation structure (31) in the second direction at a position corresponding to the first isolation structure (31), to cause the connection structure (32) to be electrically connected to the second electrode layer (52).

8. The thin-film solar cell (1) according to claim 6 or 7, **characterized in that** in the first direction, a distance (d1) between the connection structure (32) and the first isolation structure (31) is greater than 0.

9. The thin-film solar cell (1) according to any one of claims 6 to 8, **characterized in that** in the first direction, a size (k1) of the first isolation structure (31) is 10 µm to 80 µm.

10. The thin-film solar cell (1) according to any one of claims 6 to 9, **characterized in that** a material of the first insulating wall (311) comprises at least one of epoxy resin, melamine formaldehyde resin, polycarbonate polymethyl methacrylate, polyethylene, polytetrafluoroethylene, phenolic plastic, silicon boron, a metal oxide, and an ionic-structured inorganic solid.

11. The thin-film solar cell (1) according to claim 5, **characterized in that** the first isolation structure (31) comprises a second insulating wall (312) and a first insulating layer (313), wherein the second insulating wall (312) extends from a second surface of the first electrode layer (51) to a first surface of the first electrode layer (51) in the second direction, the first insulating layer (313) is attached to a side of the connection structure (32) close to the second insulating wall (312), the first surface of the first electrode layer (51) is a surface of the first electrode layer (51) far from the substrate (20), and the second surface of the first electrode layer (51) is a surface of the first electrode layer (51) close to the substrate (20).

12. The thin-film solar cell (1) according to any one of claims 1 to 11, **characterized in that** the second isolation structure (33) is a groove extending from the second electrode layer (52) to the first electrode layer (51) in the second direction.

13. The thin-film solar cell (1) according to claim 12, **characterized in that** the second isolation structure (33) extends from the first surface of the second electrode layer (52) to the first surface of the first electrode layer (51) in the second direction, wherein the first surface of the second electrode layer (52) is a surface of the second electrode layer (52) far from the first electrode layer (51), and the first surface of the first electrode layer (51) is a surface of the first electrode layer (51) far from the substrate (20).

14. The thin-film solar cell (1) according to claim 12 or 13, **characterized in that** in the first direction, a size (k2) of the second isolation structure (33) is 30 µm to 100 µm.

15. The thin-film solar cell (1) according to any one of claims 1 to 14, **characterized in that** in the first direction, a distance (d2) between the first isolation structure (31) and the second isolation structure (33) is 200 µm to 300 µm.

16. The thin-film solar cell (1) according to any one of claims 1 to 15, **characterized in that** in the first direction, a size (k3) of the connection structure (32) is 30 µm to 100 µm.

17. The thin-film solar cell (1) according to any one of claims 1 to 16, **characterized in that** in the first direction, a size (k4) of the cell unit (2) is 6 mm to 10 mm.

18. The thin-film solar cell (1) according to any one of claims 4 to 17, **characterized in that** a bandgap of the first light absorption layer (54) is greater than a bandgap of the second light absorption layer (58).

19. The thin-film solar cell (1) according to claim 18, **characterized in that** both the first light absorption layer (54) and the second light absorption layer (58) are perovskite layers.

20. The thin-film solar cell (1) according to claim 18, **characterized in that** the first light absorption layer (54) is a copper indium gallium selenium layer, and the second light absorption layer (58) is a perovskite layer.

21. The thin-film solar cell (1) according to any one of claims 4 to 20, **characterized in that** a thickness (a1) of the first charge transport layer (53) is 10 nm to 30 nm, a thickness (a2) of the first light absorption layer (54) is 100 nm to 400 nm, a thickness (a3) of the second charge transport layer (55) is 20 nm to 60 nm, a thickness (a4) of the third electrode layer (56) is 1 nm to 3 nm, a thickness (a5) of the third charge transport layer (57) is 10 nm to 30 nm, a thickness (a6) of the second light absorption layer (58) is 600 nm to 800 nm, a thickness (a7) of the fourth charge transport layer (59) is 30 nm to 50 nm, and a thickness (a8) of the second electrode layer (52) is 100 nm to 200 nm.

22. An electric apparatus, **characterized by** comprising the thin-film solar cell (1) according to any one of claims 1 to 21, wherein the thin-film solar cell (1) is configured to supply power to the electric apparatus.
